# EUROPÄISCHE PATENTSCHRIFT

(11) **EP 3 096 361 B1**
(45) Veröffentlichungstag und Bekanntmachung des Hinweises auf die Patenterteilung: **09.03.2022**
(21) Anmeldenummer: 16001051.8
(22) Anmeldetag: 10.05.2016
(51) Int. Cl.: H01L 31/0687, H01L 31/0693, H01L 31/02

(54) **SKALIERBARE SPANNUNGSQUELLE**
SCALABLE VOLTAGE SOURCE
SOURCE DE TENSION ECHELONNABLE

(30) Priorität: 18.05.2015 DE 102015006379
(43) Veröffentlichungstag der Anmeldung: 23.11.2016
(73) Patentinhaber: AZUR SPACE Solar Power GmbH, 74072 Heilbronn (DE)
(72) Erfinder: Fuhrmann, Daniel, 74081 Heilbronn (DE); Guter, Wolfgang, 70190 Stuttgart (DE); Khorenko, Victor, 74196 Neuenstadt a.K. (DE)
(74) Vertreter: Koch Müller Patentanwaltsgesellschaft mbH

(56) Entgegenhaltungen:
- WO-A1-2014/096200
- CN-A- 102 651 416
- DE-A1-102011 000 521
- US-A1- 2006 048 811
- US-A1- 2012 266 803
- VALDIVIA CHRISTOPHER E ET AL: "Five-volt vertically-stacked, single-cell GaAs photonic power converter", PROCEEDINGS OF SPIE, Bd. 9358, 16. März 2015 (2015-03-16), Seiten 93580E-1-93580E-8, XP060049977, DOI: 10.1117/12.2079824 ISBN: 978-1-62841-730-2
- SCHUBERT J ET AL: "High-Voltage GaAs Photovoltaic Laser Power Converters", IEEE TRANSACTIONS ON ELECTRON DEVICES, IEEE SERVICE CENTER, PISACATAWAY, NJ, US, Bd. 56, Nr. 2, Februar 2009 (2009-02), Seiten 170-175, XP011241423, ISSN: 0018-9383, DOI: 10.1109/TED.2008.2010603
- Andreas W. Bett ET AL: "III-V solar cells under monochromatic illumination", 2008 33rd IEEE Photovolatic Specialists Conference, 1 May 2008 (2008-05-01), pages 1-5, XP055103509, ISSN: 0160-8371, DOI: 10.1109/PVSC.2008.4922910 ISBN: 978-1-42-441640-0

## Beschreibung

Die Erfindung betrifft eine skalierbare Spannungsquelle.

Aus der US 4 127 862, der US 6 239 354 B1, der DE 10 2010 001 420 A1, aus Nader M. Kalkhoran, et al, "Cobalt disilicide intercell ohmic contacts for multijunction photovoltaic energy converters", Appl. Phys. Lett. 64, 1980 (1994) und aus A. Bett et al, "III-V Solar cells under monochromatic illumination", Photovoltaic Specialists Conference, 2008, PVSC '08. 33rd IEEE, Seite 1-5, ISBN:978-1-4244-1640-0 sind skalierbare Spannungsquellen oder auch Solarzellen aus III-V Materialien bekannt. Auch aus Valdivia Christopher et a al; "Five-volt vertically-stacked, single-cell GaAs photonic power converter" pro-ceedings of Spie, bd. 9358, 16. März 2015, Seiten 1 -8, ISBN 978-1-62841-730-2, der US 2006 / 048811 A1, der Wo 2014 / 096200 A1 und Schubert et al, "High-Voltage GaAs Photovoltaic Laser Power Converters", IEEE Transactions on electronic devices, Bd 56, Nr. 2 Februar 2009, Seiten 170-175, ISSN: 0018-9383 sind gattungsgemäße Spannungsquellenanordnungen bekannt.

Weitere skalierbare Spannungsquellen sind aus der CN 102 651 416 A, der US 2012/266803 A1, der DE 10 2011 000 521 A1 sowie aus Andreas W. Bett et al: "III-V solar cells under monochromatic illumination", 33rd IEEE Photovoltaic Specialists Conference, Mai 2008, S. 1-5, XP055103509, ISSN: 0160-8371, DOI: 10.1109/PVSC.2008.4922910, ISBN: 978-1-42-441640-0 bekannt. Die Druckschrift CN 102 651 416 A offenbart den Oberbegriff des Anspruchs 1.

Vor diesem Hintergrund besteht die Aufgabe der Erfindung darin, eine Vorrichtung anzugeben, die den Stand der Technik weiterbildet.

Die Aufgabe wird durch eine skalierbare Spannungsquelle mit den Merkmalen des Patentanspruchs 1 gelöst. Vorteilhafte Ausgestaltungen der Erfindung sind Gegenstand von Unteransprüchen.

### Beschreibungsseite 1A (rein)

Gemäß dem Gegenstand der Erfindung wird skalierbare Spannungsquelle aufweisend eine Anzahl N zueinander in Serie geschalteten als Halbleiterdioden ausgebildete Teilspannungsquellen bereitgestellt, wobei jede der Teilspannungsquellen eine Halbleiterdiode mit einen p-n Übergang aufweist, und die Halbleiterdiode eine p-dotierte Absorptionsschicht aufweist, wobei die p-Absorptionsschicht von einer p-dotierten Passivierungsschicht mit einer größeren Bandlücke als die Bandlücke der p-Absorptionsschlcht passiviert ist und die Halbleiterdiode eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist, und die Teilquellenspannungen der einzelnen Teilspannungsquellen zueinander einer Abweichung kleiner als 20% aufweisen, und zwischen jeweils zwei aufeinanderfolgenden Teilspannungsquellen eine Tunneldiode ausgebildet ist, wobei die Tunneldiode mehrere Halbleiterschichten mit einer höheren Bandlücke als die Bandlücke der p / n Absorptionsschichten aufweist und die Halbleiterschichten mit der höheren Bandlücke jeweils aus einem Material mit geänderter Stöchiometrie und / oder anderer Elementzusammensetzung als die p / n -Absorptionsschichten der Halbleiterdiode bestehen, und die Teilspannungsquellen und die Tunneldioden zusammen monolithisch integriert sind, und gemeinsam einen ersten Stapel mit einer Oberseite und einer Unterseite ausbilden, und die Anzahl N der Teilspannungsquellen größer gleich drei ist, und das Licht an der Oberseite auf den ersten Stapel auftrifft und die Größe der Beleuchtungsfläche an der Stapeloberseite im Wesentlichen der Größe der Fläche des ersten Stapels an der Oberseite ist, und der erste Stapel eine Gesamtdicke kleiner als 12µm aufweist, und bei 300 K der erste Stapel eine Quellenspannung von größer als 3 Volt aufweist, sofern der erste Stapel mit einem Photonenstrom bestrahlt ist, und wobei in Lichteinfallsrichtung von der Oberseite des ersten Stapels hin zu der Unterseite des ersten Stapels die Gesamtdicke der p und n -Absorptionsschichten einer Halbleiterdiode von der obersten Diode hin zu der untersten Diode zunimmt und die Spannungsquelle in der Nähe der Unterseite der Stapel einen umlaufenden, absatzförmigen Rand aufweist.

Es sei angemerkt, dass mit dem Ausdruck wesentlich in Zusammenhang des Vergleichs der Beleuchtungsfläche an der Stapeloberseite mit der Größe der Fläche des ersten Stapels an der Oberseite verstanden wird, einen Unterschied in der Fläche insbesondere kleiner als 20% oder vorzugsweise kleiner als 10% oder vorzugsweise kleiner als 5% oder höchst vorzugsweise die beiden Flächen gleich sind.

Auch sei angemerkt, dass mit dem Ausdruck "Licht" zur Bestrahlung der Stapeloberseite, ein Licht verstanden wird, welches ein Spektrum an Wellenlängen in dem Bereich der Absorption der Absorptionsschichten aufweist. Es versteht sich, dass auch ein monochromatisches Licht, welches eine bestimmte d.h. absorbierende Wellenlänge aufweist, also eine Wellenlänge in dem Bereich der Absorption der Absorptionsschichten, geeignet ist.

Es versteht sich, dass die vorzugsweise die gesamte Oberseite des ersten Stapels d.h. die gesamte oder nahezu die gesamte Oberfläche mit Licht einer bestimmten Wellenlänge bestrahlt wird. Es sei angemerkt, dass eingehende Untersuchungen in überraschender Weise zeigten, dass im Unterschied zu dem Stand der Technik sich in vorteilhafter Weise mit dem vorliegenden monolithischen Stapelansatz Quellenspannungen oberhalb von 3V ergeben.

Ein Vorteil der erfindungsgemäßen Vorrichtung ist es, dass durch die Hintereinanderschaltung von einer Vielzahl von Teilspannungsquellen eine Spannungsquelle mit Spannungswerten auch oberhalb von vier oder mehr Volt sich mittels eines monolithisch integrierten Aufbau eine einfache und kostengünstige sowie eine zuverlässige Spannungsquelle herstellen lässt. Ein weiterer Vorteil ist, dass mittels der stapelförmigen Anordnung im Vergleich zu der bisherigen lateralen Anordnung mit Siliziumdioden eine große Flächeneinsparung ergibt. Insbesondere muss von der Sendediode oder der Lichtquelle nur die wesentlich kleinere Empfangsfläche des Stapels beleuchtet werden.

In einer Weiterbildung weicht die Teilquellenspannungen der einzelnen Teilspannungsquellen untereinander weniger als 10% ab. Hierdurch wird die Einsetzbarkeit als skalierbare Spannungsquelle insbesondere als Referenzspannungsquelle wesentlich verbessert. Es versteht sich, dass sich der Begriff der "Skalierbarkeit" auf die Höhe der Quellenspannung des gesamten Stapels bezieht.

In einer anderen Weiterbildung weisen die Halbleiterdioden jeweils das gleiche Halbleitermaterial auf, wobei hierbei das Halbleitermaterial der Dioden die gleiche kristalline Zusammensetzung aufweist und vorzugsweise die Stöchiometrie nahezu oder vorzugsweise genau gleich ist. Auch ist es vorteilhaft, den ersten Stapel auf einem Substrat anzuordnen. In einer Ausführungsform besteht das Halbleitermaterial und / oder das Substrat aus III-V Materialien. Insbesondere ist bevorzugt, dass das Substrat Germanium oder Galliumarsenid umfasst und / oder die Halbleiterschichten auf dem Substrat Arsen und / oder Phosphor aufweisen. Anders ausgedrückt umfassen die Halbleiterschichten As-haltige Schichten und P -haltige Schichten, d.h. Schichten aus GaAs oder AlGaAs oder InGaAs als Beispiele für Arsenid-Schichten und InGaP als ein Beispiel für Phosphid-Schichten.

Es ist Teil der Erfindung, auf der Unterseite des ersten Stapels ein zweiter Spannungsanschluss auszubilden und insbesondere, dass der zweite Spannungsanschluss durch das Substrat ausgebildet ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Es ist vorteilhaft, wenn die Halbleiterdioden grundsätzlich aus einem III-V Material bestehen. Insbesondere ist es bevorzugt, GaAs zu verwenden.

Erfindungsgemäß ist auf der Oberseite des ersten Stapels ein erster Spannungsanschluss als ein umlaufender Metallkontakt in der Nähe des Randes oder als einzelne Kontaktfläche an dem Rand ausgebildet.

Des Weiteren ist es bevorzugt, wenn der erste Stapel eine Grundfläche kleiner als 2 mm² oder kleiner als 1 mm² aufweist. Untersuchungen haben gezeigt, dass es vorteilhaft ist, die Grundfläche viereckig auszubilden. Vorzugsweise ist die Grundfläche des Stapels quadratisch ausgebildet.

Weitere Untersuchungen haben gezeigt, dass um besonderes hohe Spannungen zu erzielen es vorteilhaft ist, einen zweiten Stapel auszubilden und die beiden Stapel miteinander in Serie zu verschalten, so dass sich die Quellenspannung des ersten Stapels und die Quellenspannung des zweiten Stapels addieren. Vorzugsweise sind der erste Stapel und der zweite Stapel nebeneinander auf einem gemeinsamen Träger angeordnet.

In einer Weiterbildung weicht die Quellenspannung des ersten Stapels von der Quellenspannung des zweiten Stapels um weniger als 15 % ab.

Des Weiteren ist es bevorzugt, dass unterhalb der untersten Halbleiterdiode des Stapels ein Halbleiterspiegel ausgebildet ist. Untersuchungen haben gezeigt, dass sich eine Vielzahl von Stapeln nebeneinander auf einem Halbleiterwafer oder Halbleitersubstratscheibe ausbilden lassen, indem nach der ganzflächigen, vorzugsweise epitaktischen Herstellung der Schichten, eine sogenannte Mesaätzung durchgeführt wird. Hierzu wird mittels eines Maskenprozesses eine Lackmaske erzeugt und anschließend vorzugsweise eine naßchemische Ätzung zur Erzeugung von Mesa-Gräben durchgeführt. Die Mesaätzung stoppt vorzugsweise in dem Substrat oder auf dem Substrat.

In einer Ausführungsform ist zwischen der p Absorptionsschicht und der n-Absorptionsschicht der jeweiligen Diode eine intrinsische Schicht ausgebildet. Hierbei wird unter einer intrinsischen Schicht eine Halbleiterschicht mit einer Dotierung unterhalb 1E16 1/cm², vorzugsweise kleiner als 5E15 1/cm², höchst vorzugsweise kleiner als 1,5 E15 1/ cm² verstanden.

In einer Weiterbildung ist es bevorzugt, dass jeder Stapel in der Nähe der Unterseite einen umlaufenden, absatzförmigen Rand aufweist, wobei bei zwei unmittelbar benachbarten Stapeln an den Außenseiten des Stapeigebildes der umlaufende Rand als ein gemeinsamer umlaufender Rand ausgebildet ist, so dass die Spannungsquelle einen umlaufenden Rand aufweist.

Vorzugsweise ist der Rand stufenförmig oder als Stufe ausgebildet. Hierbei weist die Oberfläche des Randes bzw. der Stufe vorzugsweise größtenteils eine plane Fläche auf, wobei die Normale der Oberfläche des Randes bzw. der Stufe parallel oder nahezu parallel zu der Normalen der Oberfläche des ersten Stapels oder der Normalen der Oberflächen der jeweiligen Stapel ausgebildet ist. Es sei angemerkt dass die Seitenfläche des Randes oder der Stufe überwiegend oder genau senkrecht zu der Oberfläche des Randes bzw. der Stufe ausgebildet ist.

Die Kante des Randes oder der Stufe ist wenigstens 5 µm und maximal 500 µm jeweils von jeder der vier Seitenflächen des ersten Stapels oder jeweils von den Seitenflächen der mehreren Stapeln entfernt. Vorzugsweise liegt der Entfernungsbereich jeweils der Kante zu der unmittelbar angrenzenden Seitenfläche zwischen 10 µm und 300 µm. Insbesondere liegt der Entfernungsbereich zwischen 50 µm und 250 µm.

Vorzugsweise sind die Seitenflächen des ersten Stapels und insbesondere alle Seitenflächen der Stapel plan und insbesondere senkrecht oder nahezu senkrecht ausgebildet. Insbesondere liegen die Normalen auf Seitenflächen im Vergleich zu den Normalen der angrenzenden Randflächen oder den Normalen der Stapeloberflächen in einen Winkelbereich zwischen 80° und 110°, d.h. die Normalen einer Seitenfläche und der unmittelbar angrenzenden Randfläche sind zueinander im Wesentlichen Orthogonal. Vorzugsweise liegt der Winkelbereich zwischen 85° und 105°.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine erste erfindungsgemäße Ausführungsform einer skalierbaren Spannungsquelle mit einem Stapel,
- Figur 2: eine zweite Ausführungsform einer skalierbaren Spannungsquelle mit mehreren Stapeln,
- Figur 3: eine Ausführungsform mit insgesamt fünf Dioden mit unterschiedlicher Dicke des Absorptionsgebiets,
- Figur 4: eine Stapel mit einer umlaufenden absatzförmigen Stufe.

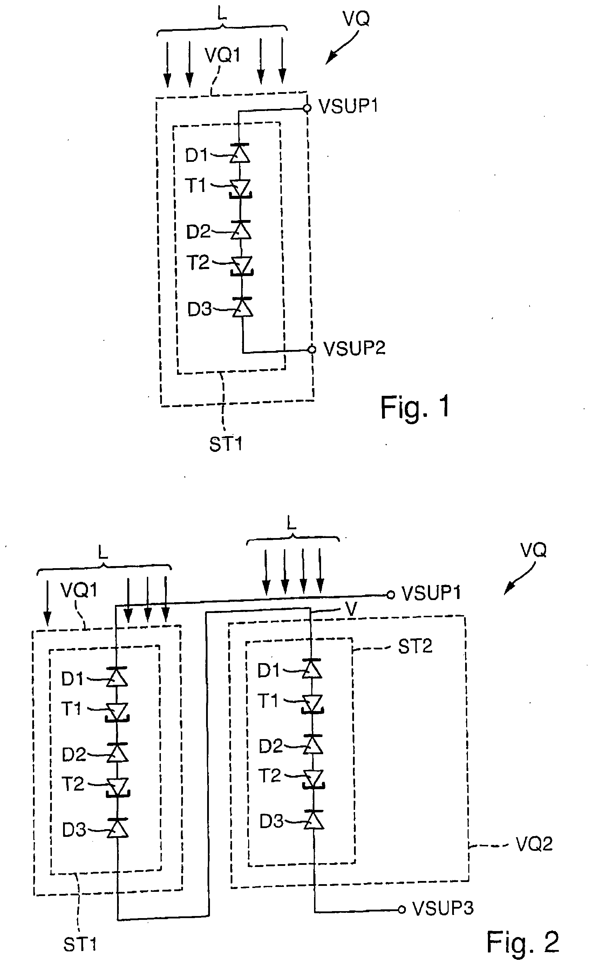

Die Abbildung der Figur 1 zeigt eine schematische Ansicht einer ersten Ausführungsform, aufweisend eine skalierbare Spannungsquelle VQ mit einem ersten Stapel ST1 mit einer Oberseite und einer Unterseite mit einer Anzahl N gleich drei Dioden. Der erste Stapel ST1 weist eine Serienschaltung aus einer ersten Diode D1 und einer ersten Tunneldiode T1 und einer zweiten Diode D2 und einer zweiten Tunneldiode T2 und einer dritten Diode D3 auf. An der Oberseite des Stapel ST1 ist ein erster Spannungsanschluss VSUP1 und der Unterseite des Stapel ST1 ein zweiter Spannungsanschluss VSUP2 ausgebildet. Die Quellenspannung VQ1 des ersten Stapel ST1 setzt sich vorliegend aus den Teilspannungen der einzelnen Dioden D1 bis D3 zusammen. Hierzu ist der erste Stapel ST1 einem Photonenstrom, d.h. dem Licht L ausgesetzt.

Der erste Stapel ST1 der Dioden D1 bis D3 und der Tunneldioden T1 und T2 ist als monolithisch ausgebildeter Block, vorzugsweise aus dem gleichen Halbleitermaterial, ausgeführt.

In der Abbildung der Figur 2 ist eine weitere Ausführungsform einer vorteilhaften Aneinanderreihung von dem ersten Stapel ST1 und einem zweiten Stapel ST2 ausgebildet. Im Folgenden werden nur die Unterschiede zu der Abbildung der Figur 1 erläutert. Der zweite Stapel ST2 weist wie der erste Stapel ST1 eine Serienschaltung aus drei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 addieren, sofern die beiden Stapel ST1 und ST2 dem Photonenstrom L ausgesetzt sind.

In einer nicht dargestellten Ausführungsform weisen die beiden Stapel ST1 und ST2 zueinander eine unterschiedliche Anzahl von jeweils in einer Serienschaltung verbundenen Dioden auf. In einer anderen nicht dargestellten Ausführungsform weist wenigstens der erste Stapel ST1 und / oder der zweite Stapel ST2 mehr als drei in einer Serienschaltung verbundene Dioden auf. Hierdurch lässt sich die Spannungshöhe der Spannungsquelle VQ skalieren. Vorzugsweise liegt die Anzahl N in einem Bereich zwischen vier und acht. In einer Weiteren nicht dargestellten Ausführungsform, sind die beiden Stapel ST1 und ST2 zueinander parallel geschaltet.

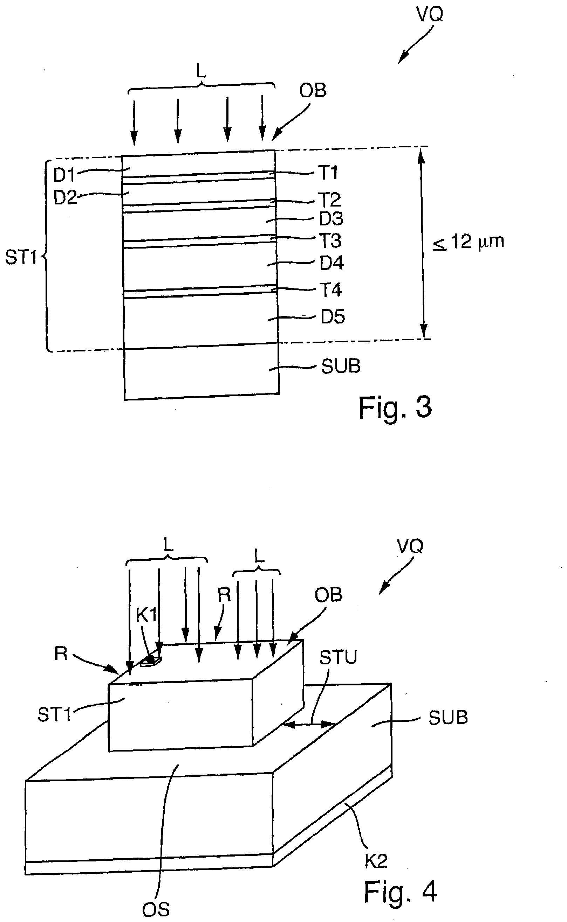

In der Abbildung der Figur 3 ist eine Ausführungsform einer vorteilhaften Aneinanderreihung von Halbleiterschichten zu dem ersten Stapel ST1 dargestellt. Im Folgenden werden nur die Unterschiede zu der Abbildung der Figur 1 erläutert. Der erste Stapel ST1 umfasst insgesamt fünf in Reihe geschaltete als Dioden D1 bis D5 ausgebildete Teilspannungsquellen. Auf die Oberfläche OB der ersten Diode D1 trifft das Licht L auf. Die Oberfläche OB wird nahezu oder vollständig ausgeleuchtet. Zwischen zwei aufeinanderfolgenden Dioden D1-D5 ist jeweils eine Tunneldiode T1-T4 ausgebildet. Mit zunehmender Entfernung der einzelnen Diode D1 bis D5 von der Oberfläche OB steigt die Dicke des Absorptionsgebiets, so dass die unterste Diode D5 das dickste Absorptionsgebiet aufweist. Insgesamt beträgt die Gesamtdicke des ersten Stapels ST1 kleiner gleich 12 µm. Unterhalb der untersten Diode D5 ist ein Substrat SUB ausgebildet.

In der Abbildung der Figur 4 ist eine Ausführungsform einer vorteilhaften Aneinanderreihung von Halbleiterschichten zu dem ersten Stapel ST1 dargestellt mit einer umlaufenden absatzförmigen Stufe. Im Folgenden werden nur die Unterschiede zu der Abbildung der Figur 3 erläutert. Auf der Oberfläche OB des ersten Stapels ST1 ist an dem Rand R ein erster metallischer Anschlusskontakt K1 ausgebildet. Der erste Anschlusskontakt K1 ist mit dem ersten Spannungsanschluss VSUP1 verschaltet - nicht dargestellt. Das Substrat SUB weist eine Oberseite OS auf, wobei die Oberseite OS des Substrats SUB stoffschlüssig mit der untersten, d.h. der fünften Diode D5 verbunden ist. Hierbei versteht es sich, dass auf dem Substrat eine dünne Nukleationsschicht und eine Pufferschicht epitaktisch erzeugt wird, bevor auf dem Substrat die fünfte Diode angeordnet wird und stoffschlüssig mit der Oberseite OS des Substrats verbunden wird. Die Oberseite OS des Substrats SUB weist eine größere Oberfläche als die Fläche an der Unterseite des ersten Stapels ST1 auf. Hierdurch bildet sich eine umlaufende Stufe STU aus. Der Rand der Stufe STU ist von der unmittelbar angrenzenden Seitenfläche des ersten Stapels ST1 der Stufe um mehr als 5µm und weniger als 500µm entfernt, dargestellt als Länge des Referenzzeichens STU. An der Unterseite des Substrats SUB ist ein zweiter ganzflächiger metallischer Kontakt K2 ausgebildet. Der zweite Anschlusskontakt K2 ist mit dem zweiten Spannungsanschluss VSUP2 verschaltet - nicht dargestellt.

## Patentansprüche

1. Skalierbare Spannungsquelle (VQ) aufweisend
- eine Anzahl N zueinander in Serie geschaltete als Halbleiterdioden ausgebildete Teilspannungsquellen, wobei jede der Teilspannungsquellen eine Halbleiterdiode (D1, D2, D3, D4, D5) mit einem p-n Übergang aufweist, und die Halbleiterdiode (D1, D2, D3, D4, D5) eine p-dotierte Absorptionsschicht aufweist und die Halbleiterdiode (D1, D2, D3, D4, D5) eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist, und die Teilquellenspannungen der einzelnen Teilspannungsquellen zueinander eine Abweichung kleiner als 20% aufweisen, und
- zwischen jeweils zwei aufeinanderfolgenden Teilspannungsquellen eine Tunneldiode (T1, T2, T3, T4) ausgebildet ist, wobei die Teilspannungsquellen und die Tunneldioden (T1, T2, T3, T4) zusammen monolithisch integriert sind, und gemeinsam einen ersten Stapel (ST1) mit einer Oberseite und einer Unterseite ausbilden, und die Anzahl N der Teilspannungsquellen größer gleich drei ist, und
- bei einer Beleuchtung des ersten Stapels (ST1) mit Licht (L), wobei das Licht (L) an der Oberseite auf die Oberfläche (OB) auf den ersten Stapel (ST1) auftrifft und die Größe der beleuchteten Oberfläche (OB) an der Stapeloberseite im Wesentlichen der Größe der Fläche des ersten Stapels an der Oberseite entspricht, und bei 300 K der erste Stapel (ST1) eine Quellenspannung (VQ1) von größer als 3 Volt aufweist, sofern der erste Stapel (ST1) mit Licht (L) bestrahlt ist, und wobei in Lichteinfallsrichtung von der Oberseite des ersten Stapels (ST1) hin zu der Unterseite des Stapels die Gesamtdicke der p und n -Absorptionsschichten einer Halbleiterdiode von der obersten Diode (D1) hin zu der untersten Diode (D3 - D5) zunimmt,
- die Tunneldioden (T1, T2, T3, T4) mehrere Halbleiterschichten mit einer höheren Bandlücke als die Bandlücke der p / n Absorptionsschichten aufweisen, und die Halbleiterschichten mit der höheren Bandlücke jeweils aus einem Material mit geänderter Stöchiometrie und / oder anderer Elementzusammensetzung als die p / n -Absorptionsschichten der Halbleiterdiode (D1, D2, D3, D4, D5) bestehen, und der erste Stapel (ST1) eine Gesamtdicke kleiner als 12µm aufweist, und jede p-Absorptionsschicht der Halbleiterdiode (D1, D2, D3, D4, D5) von einer p-dotierten Passivierungsschicht mit einer größeren Bandlücke als die Bandlücke der p-Absorptionsschicht passiviert ist, und der erste Stapel (ST1) auf einem Substrat (SUB) angeordnet ist und das Substrat (SUB) ein Halbleitermaterial umfasst, und auf der Oberseite des ersten Stapels (ST1) ein erster Spannungsanschluss (VSUP1) als ein umlaufender erster Metallkontakt (K1) in der Nähe des Randes (R) oder als eine einzelne Kontaktfläche (K1) an dem Rand (R) ausgebildet ist, **dadurch gekennzeichnet, dass**
- eine Oberseite (OS) des Substrats (SUB) stoffschlüssig mit der untersten Diode verbunden ist,
- die Oberseite (OS) des Substrats (SUB) eine größere Oberfläche als die Fläche an der Unterseite des ersten Stapels ST1 aufweist, so dass sich in der Nähe der Unterseite des ersten Stapels (ST1) einen umlaufenden, absatzförmigen Rand ausbildet und
- ein zweiter Spannungsanschluss (VSUP2) als ein ganzflächiger metallischer Anschlusskontakt (K2) an einer Unterseite des Substrats (SUB) ausgebildet ist.

2. Skalierbare Spannungsquelle (VQ) nach Anspruch 1, **dadurch gekennzeichnet, dass** die Teilquellenspannungen der Teilspannungsquellen zueinander eine Abweichung kleiner als 10% aufweisen.

3. Skalierbare Spannungsquelle (VQ) nach Anspruch 1 oder Anspruch 2, **dadurch gekennzeichnet, dass** die Halbleiterdioden (D1, D2, D3, D4, D5) jeweils das gleiche Halbleitermaterial aufweisen.

4. Skalierbare Spannungsquelle (VQ) nach einem der vorangegangenen Ansprüche, **dadurch gekennzeichnet, dass** der erste Stapel (ST1) eine Grundfläche kleiner als 2 mm² oder kleiner als 1 mm² aufweist.

5. Skalierbare Spannungsquelle (VQ) nach Anspruch 4, **dadurch gekennzeichnet, dass** die Grundfläche viereckig ausgebildet ist.

6. Skalierbare Spannungsquelle (VQ) nach einem der vorangegangenen Ansprüche, **dadurch gekennzeichnet, dass** ein zweiter Stapel (ST2) ausgebildet ist und der erste Stapel (ST1) und der zweite Stapel (ST2) nebeneinander auf einem gemeinsamen Träger angeordnet sind und die beiden Stapel (ST1, ST2) miteinander in Serie verschaltet sind, so dass sich die Quellenspannung (VQ1) des ersten Stapels (ST1) und die Quellenspannung (VQ2) des zweiten Stapels (ST2) addieren.

7. Skalierbare Spannungsquelle (VQ) nach einem der vorangegangenen Ansprüche, **dadurch gekennzeichnet, dass** zwischen der p Absorptionsschicht und der n-Absorptionsschicht der jeweiligen Diode eine intrinsische Schicht ausgebildet ist.

8. Skalierbare Spannungsquelle (VQ) nach einem der vorangegangenen Ansprüche, **dadurch gekennzeichnet, dass** das Halbleitermaterial und / oder das Substrat aus III-V Materialien bestehen.

9. Skalierbare Spannungsquelle (VQ) nach einem der vorangegangenen Ansprüche, **dadurch gekennzeichnet, dass** das Substrat Germanium oder Galliumarsenid umfasst.

10. Skalierbare Spannungsquelle (VQ) nach einem der vorangegangenen Ansprüche, **dadurch gekennzeichnet, dass** unterhalb der untersten Halbleiterdiode des Stapels ein Halbleiterspiegel ausgebildet ist.

11. Skalierbare Spannungsquelle (VQ) nach einem der vorangegangenen Ansprüche, **dadurch gekennzeichnet, dass** die Halbleiterschichten des Stapels (ST1) gleichzeitig Arsenid-haltige Schichten und Phosphidhaltige Schichten umfassen.

12. Skalierbare Spannungsquelle (VQ) nach einem der vorangegangenen Ansprüche, **dadurch gekennzeichnet, dass** die Kante des Randes wenigstens 5 µm und maximal 500 µm von der unmittelbar angrenzenden Seitenfläche der Stapel entfernt ist.

## Claims

1. Scalable voltage source (VQ) comprising
- a number N of component voltage sources connected in series with one another and constructed as semiconductor diodes, wherein each of the component voltage sources comprises a semiconductor diode (D1, D2, D3, D4, D5) with a p-n transition and the semiconductor diode (D1, D2, D3, D4, D5) has a p-doped absorption layer and the semiconductor diode (D1, D2, D3, D4, D5) has an n absorption layer, wherein the n absorption layer is passivated by an n-doped passivation layer with a greater band gap than the band gap of the n absorption layer,
and the component source voltages of the individual component voltage sources have a difference of less than 20% from one another, and
- a tunnel diode (T1, T2, T3, T4) is formed between each two successive component voltage sources, wherein the component voltage sources and the tunnel diodes (T1, T2, T3, T4) are monolithically integrated together, and in common form a first stack (ST1) with an upper side and a lower side, and the number N of the component voltage sources is greater than or equal to three, and
- in the case of illumination of the first stack (ST1) with light (L), wherein the light (L) is incident on the surface (OB) on the first stack (ST1) at the upper side and the size of the illuminated surface (OB) at the stack upper side substantially corresponds with the size of the area of the first stack at the upper side, and at 300 K the first stack (ST1) has a source voltage (VQ1) of greater than 3 volts insofar as the first stack (ST1) is irradiated with light (L), and wherein in the direction of light incidence from the upper side of the first stack (ST1) towards the lower side of the stack the total thickness of the p and n absorption layers of a semiconductor diode increases from the uppermost diode (D1) towards the lowermost diode (D3 - D5),
- the tunnel diodes (T1, T2, T3, T4) comprise a plurality of semiconductor layers with a higher band gap than the band gap of the p and n absorption layers, and the semiconductor layers with the higher band gap each consist of a material with modified stoichiometry and/or different element composition compared with the p and n absorption layers of the semiconductor diode (D1, D2, D3, D4, D5), and
the first stack (ST1) has an overall thickness less than 12 µm, and each p absorption layer of the semiconductor diode (D1, D2, D3, D4, D5) is passivated by a p-doped passivation layer with a greater band gap than the band gap of the p absorption layer, and the first stack (ST1) is arranged on a substrate (SUB) and the substrate (SUB) comprises a semiconductor material, and
a first voltage terminal (VSUP1) as an encircling first metal contact (K1) in the vicinity of the edge (R) or as an individual contact area (K1) at the edge (R) is formed on the upper side of the first stack (ST1),
**characterised in that**
- an upper side (OS) of the substrate (SUB) is connected by material couple with the lowermost diode,
- the upper side (OS) of the substrate (SUB) has a larger surface than the area at the lower side of the first stack (ST1) so that an encircling shoulder-shaped edge forms in the vicinity of the lower side of the first stack (ST1) and
- a second voltage terminal (VSUP2) is formed as a whole-area metallic terminal contact (K2) at a lower side of the substrate (SUB).

2. Scalable voltage source (VQ) according to claim 1, **characterised in that** the component source voltages of the component voltage sources have a difference of less than 10% from one another.

3. Scalable voltage source (VQ) according to claim 1 or claim 2, **characterised in that** the semiconductor diodes (D1, D2, D3, D4, D5) respectively comprise the same semiconductor material.

4. Scalable voltage source (VQ) according to any one of the preceding claims, **characterised in that** the first stack (ST1) has a base area less than 2 mm² or less than 1 mm².

5. Scalable voltage source (VQ) according to claim 4, **characterised in that** the base area is formed to be four-sided.

6. Scalable voltage source (VQ) according to any one of the preceding claims, **characterised in that** a second stack (ST2) is formed and the first stack (ST1) and the second stack (ST2) are arranged adjacent to one another on a common support and the two stacks (ST1, ST2) are connected together in series so that the source voltage (VQ1) of the first stack (ST1) and the source voltage (VQ2) of the second stack (ST2) summate.

7. Scalable voltage source (VQ) according to any one of the preceding claims, **characterised in that** an intrinsic layer is formed between the p absorption layer and the n absorption layer of the respective diode.

8. Scalable voltage source (VQ) according to any one of the preceding claims, **characterised in that** the semiconductor material and/or the substrate consists or consist of III-V materials.

9. Scalable voltage source (VQ) according to any one of the preceding claims, **characterised in that** the substrate comprises germanium or gallium-arsenide.

10. Scalable voltage source (VQ) according to any one of the preceding claims, **characterised in that** a semiconductor mirror is formed below the lowermost semiconductor diode of the stack.

11. Scalable voltage source (VQ) according to any one of the preceding claims, **characterised in that** the semiconductor layers of the stack (ST1) at the same time comprise layers with arsenide content and layers with phosphide content.

12. Scalable voltage source (VQ) according to any one of the preceding claims, **characterised in that** the brink of the edge is at least 5 µm and at most 500 µm distant from the directly adjoining side surface of the stack.

## Revendications

1. Source de tension évolutive (VQ) comprenant
- un certain nombre N de sources de tension partielles, montées en série les unes avec les autres et réalisées sous forme de diodes à semi-conducteur, chacune des sources de tension partielles présentant une diode à semi-conducteur (D1, D2, D3, D4, D5) avec une jonction p-n, et où la diode à semi-conducteur (D1, D2, D3, D4, D5) présente une couche d'absorption dotée p et où la diode à semi-conducteur (D1, D2, D3, D4, D5) présente une couche d'absorption n, la couche d'absorption n étant passivée par une couche de passivation dotée n avec une interruption de bande plus grande que l'interruption de bande de la couche d'absorption n, et où les tensions de source partielle des différentes sources de tension partielle préseneant un écart mutuel inférieur à 20%, et
- où une diode tunnel (T1, T2, T3, T4) est formée entre respectivement deux sources de tension partielle successives, les sources de tension partielle et les diodes tunnel (T1, T2, T3, T4) étant intégrées ensemble de manière monolithique, et forment ensemble un premier empilage (ST1) avec une face supérieure et une face inférieure, où le nombre N des sources de tension partielle est supérieur ou égal à trois, et
- lors d'un éclairage du premier empilage (ST1) avec une lumière (L), la lumière (L) étant incidente sur la surface (OB) supérieure du premier empilage (ST1) et où la taille de la surface éclairée (OB) supérieure de l'empilage correspondant sensiblement à la taille de la surface supérieure du premier empilage, et où - à 300 K - le premier empilage (ST1) présente une tension de source (VQ1) supérieure à 3 volts, dans la mesure où le premier empilage (ST1) est irradié par de la lumière (L), et où, dans la direction d'incidence de la lumière, de la face supérieure du premier empilage (ST1) vers la face inférieure de l'empilage, l'épaisseur totale des couches d'absorption p et n d'une diode à semi-conducteur augmente de la diode supérieure (D1) vers la diode inférieure (D3 - D5),
- où les diodes tunnel (T1, T2, T3, T4) comportent plusieurs couches semi-conductrices ayant une interruption de bande plus large que l'interruption de bande des couches d'absorption p / n, et où les couches semi-conductrices ayant l'interruption de bande plus large sont chacune constituées d'un matériau ayant une stoechiométrie modifiée et/ou d'une composition élémentaire différente de celle des couches d'absorption p / n de la diode semi-conductrice (D1, D2, D3, D4, D5), et où le premier empilage (ST1) est d'une épaisseur totale inférieure à 12 µm, et où chaque couche d'absorption p de la diode semi-conductrice (D1, D2, D3, D4, D5) est passivée par une couche de passivation dotée p ayant une interruption de bande supérieure à l'interruption de bande de la couche d'absorption p, et où le premier empilage (ST1) est disposé sur un substrat (SUB) comprenant un matériau semi-conducteur, et où sur la face supérieure du premier empilage (ST1), une première borne de tension (VSUP1) est formée soit comme un premier contact métallique périphérique (K1) à proximité du bord (R), soit comme une surface de contact (K1) individuelle sur le bord (R),
**caractérisé en ce que**
- une face supérieure (OS) du substrat (SUB) est reliée à la diode la plus basse par une liaison de matière,
- la face supérieure (OS) du substrat (SUB) présente une surface plus grande que la surface inférieure du premier empilage (ST1), de sorte qu'un bord périphérique en forme de décrochement se forme à proximité de la face inférieure du premier empilage (ST1) et
- une deuxième connexion de tension (VSUP2) est formée sous forme de contact surfacique métallique (K2 ) sur toute la surface inférieure du substrat (SUB).

2. Source de tension évolutive (VQ) selon la revendication 1, **caractérisée en ce que** les tensions de source partielle des sources de tension partielle présentent entre elles un écart inférieur à 10%.

3. Source de tension évolutive (VQ) selon la revendication 1 ou la revendication 2, **caractérisée en ce que** les diodes semi-conductrices (D1, D2, D3, D4, D5) présentent chacune le même matériau semi-conducteur.

4. Source de tension évolutive (VQ) selon l'une des revendications précédentes, **caractérisée en ce que** le premier empilage (ST1) présente une surface de base inférieure à 2 mm² ou inférieure à 1 mm².

5. Source de tension évolutive (VQ) selon la revendication 4, **caractérisée en ce que** la surface de base est quadrangulaire.

6. Source de tension évolutive (VQ) selon l'une des revendications précédentes, **caractérisée en ce qu'**un deuxième empilage (ST2) est formé et que le premier empilage (ST1) et le deuxième empilage (ST2) sont disposés l'un à côté de l'autre sur un support commun et que les deux empilages (ST1, ST2) sont connectés en série l'un avec l'autre, de sorte que la tension de source (VQ1) du premier empilage (ST1) et la tension de source (VQ2) du deuxième empilage (ST2) s'additionnent.

7. Source de tension évolutive (VQ) selon l'une des revendications précédentes, **caractérisée en ce qu'**une couche intrinsèque est formée entre la couche d'absorption p et la couche d'absorption n de la diode respective.

8. Source de tension évolutive (VQ) selon l'une des revendications précédentes, **caractérisée en ce que** le matériau semi-conducteur et/ou le substrat sont constitués de matériaux III-V.

9. Source de tension évolutive (VQ) selon l'une des revendications précédentes, **caractérisée en ce que** le substrat comprend du germanium ou de l'arséniure de gallium.

10. Source de tension évolutive (VQ) selon l'une des revendications précédentes, **caractérisée en ce qu'**un miroir semi-conducteur est formé sous la diode semi-conductrice la plus basse de l'empilage.

11. Source de tension évolutive (VQ) selon l'une des revendications précédentes, **caractérisée en ce que** les couches semi-conductrices de l'empilage (ST1) comprennent à la fois des couches contenant de l'arséniure et des couches contenant du phosphure.

12. Source de tension évolutive (VQ) selon l'une des revendications précédentes, **caractérisée en ce que** l'arête du bord est distante d'au moins 5 µm et d'au plus 500 µm de la surface latérale immédiatement adjacente des empilages.
